# EUROPEAN PATENT APPLICATION

(11) **EP 3 879 625 A1**
(43) Date of publication of application: **15.09.2021**
(21) Application number: 21159955.0
(22) Date of filing: 01.03.2021
(51) Int. Cl.: H01Q 1/24, H01Q 3/26, H01R 12/79, H05K 1/11, H01Q 1/50

(54) **PRINTED CIRCUIT BOARD, CALIBRATION BOARD AND BASE STATION ANTENNA**

(30) Priority: 13.03.2020 CN 202010173126
(71) Applicant: CommScope Technologies LLC, Hickory, NC 28602 (US)
(72) Inventor: WANG, Xiaotuo, Suzhou, Jiangsu 215021 (CN); ZHANG, Xun, Suzhou, Jiangsu 215021 (CN); WEN, Hangsheng, Suzhou, Jiangsu 215021 (CN); LI, Haifeng, Suzhou, Jiangsu 215021 (CN)
(74) Representative: Parker, Andrew James

(57) **Abstract**

Printed circuit boards suitable for base station antennas have a first through hole for receiving a conductor of an electrical connector and a first conductive trace for electrical connection with the conductor to transmit signals. The first conductive trace is provided on a first side of the printed circuit board and the electrical connector is located on the same side of the first conductive trace when mounted on the printed circuit board. The conductor is electrically connected to the first conductive trace via a bypass provided on a second side of the printed circuit board, opposite to the first side. The printed circuit board can be provided for a base station antenna that includes a calibration board including the printed circuit board. The printed circuit board can facilitate the good positioning of the electrical connector thereon, the good electrical performances, or can avoid a possible short circuit.

## Description

### RELATED APPLICATIONS

This patent application claims priority to and the benefit of Chinese Patent Application Serial Number 202010173126.4 filed March 13, 2020, the content of which is hereby incorporated by reference as if recited in full herein.

### FIELD

The present disclosure generally relates to communication systems. More specifically, the present disclosure relates to a printed circuit board for a base station antenna, a calibration board including the printed circuit board, and a base station antenna including the printed circuit board.

### BACKGROUND

Cellular communication systems are used to provide wireless communications to fixed and mobile subscribers. A cellular communication system may include a plurality of base stations, each of which provides a wireless cellular service for a specific coverage area that is typically referred to as a "cell". Each base station may include one or more base station antennas for transmitting radio frequency ("RF") signals to and receiving RF signals from the subscribers that are within the cell served by the base station.

The base station antenna may include a plurality of radiating elements, also referred to as radiators, antenna oscillators, or antenna elements. These radiating elements may be mounted on an antenna substrate, which may typically include a feed board, a reflection board and a calibration board. The feed board includes a feed network for feeding the radiating elements of the base station antenna, and the calibration board includes a calibration network for calibrating the amplitude and phase of signals transmitted to the feed network. The feed board and the calibration board are usually made from printed circuit boards.

### SUMMARY

An object of the present disclosure is to provide a printed circuit board for a base station antenna, which may be configured as a calibration board of the base station antenna and can overcome at least one drawback in calibration boards of the prior art.

The subject matter of the present disclosure will be illustrated according to various aspects described below. The clauses in the Summary are provided as examples, rather than limiting the subject matter of the present disclosure.

Embodiments are directed to a printed circuit board having a first through hole for receiving a conductor of an electrical connector and a first conductive trace for electrically connecting with the conductor of the electrical connector to transmit signals. The first conductive trace is provided on a first side of the printed circuit board and the electrical connector is located on the same side of the first conductive trace when mounted on the printed circuit board. The conductor of the electrical connector is electrically connected to the first conductive trace via a bypass provided on a second side of the printed circuit board opposite the first side.

The bypass can include a second conductive trace on the second side of the printed circuit board and a can also include a second through hole for electrically connecting the first conductive trace and the second conductive trace. The second conductive trace can be further configured to electrically connect the conductor of the electrical connector received in the first through hole and the second through hole.

The second through hole can be configured as a plated through hole.

The second conductive trace can be a microstrip line.

The second conductive trace can be a coplanar waveguide.

The first through hole can be configured as a non-plated through hole.

The first through hole can be sized substantially equal to the conductor of the electrical connector.

The first conductive trace can be spaced apart from the electrical connector by a distance in a length direction of the first conductive trace.

The first conductive trace cam be a microstrip line.

The printed circuit board can further include a third through hole that can be configured for receiving a ground pin of the electrical connector.

The third through hole, where used, can be a plated through hole.

The third through hole, where used, can be a non-plated through hole.

The printed circuit board can include a first ground layer on the first side of the printed circuit board and can include a second ground layer on the second side of the printed circuit board. A dielectric layer can reside between the first ground layer and the second ground layer.

The first ground layer and/or the second ground layer can be metal layers.

The printed circuit board can be configured as a calibration board for a base station antenna.

The electrical connector can be an electrical receptacle element for receiving a cable interface of a remote radio unit.

The electrical receptacle element can be a male straight receptacle element.

Embodiments of the invention are directed to a calibration board that has a printed circuit board according to any of the above clauses and can have one or more electrical connectors mounted on the printed circuit board.

Embodiments of the invention are directed to a base station antenna that can have a calibration board including a printed circuit board according to any one or more of the clauses above and one or more electrical connectors mounted on the printed circuit board.

It is to be noted that, various aspects of the present disclosure described with respect to one embodiment, although not specifically described with respect to other different embodiments, may be incorporated into the other different embodiments. In other words, all embodiments and/or features in any embodiments may be combined in any manner and/or combination, as long as they do not contradict each other.

### BRIEF DESCRIPTION OF THE DRAWINGS

After reading the embodiments below in combination with the drawings, a plurality of aspects of the present disclosure will be better understood. In the drawings:
FIG. 1 is a perspective view of a calibration board in the prior art;
FIG. 2 is an exploded view of the calibration board of FIG. 1;
FIG. 3 is a partially enlarged top view of an electrical receptacle portion of the calibration board of FIG. 1;
FIG. 4 is a partially enlarged bottom view of the electrical receptacle portion of the calibration board of FIG. 1;
FIG. 5 is a perspective top view of a calibration board according to an embodiment of the present disclosure;
FIG. 6 is a perspective bottom view of the calibration board of FIG. 5; and
FIG. 7 is an exploded view of the calibration board of FIG. 5.

It is to be understood that like numbers refer to like elements throughout. In the drawings, for the sake of clarity, sizes of certain features may be modified and may not be drawn to scale.

### DETAILED DESCRIPTION

The present disclosure will be described below with reference to the drawings, in which several embodiments of the present disclosure are shown. However, it is to be understood that the present disclosure may be embodied in many different forms and should not be construed as limited to the embodiments that are described herein. In fact, the embodiments described hereinafter are intended to make a more complete disclosure of the present disclosure and to adequately explain the scope of the present disclosure to a person skilled in the art. It should also be understood that, the embodiments disclosed herein can be combined in various ways to provide more additional embodiments.

It should be understood that, the wordings in the specification are only used for describing particular embodiments and are not intended to limit the present disclosure. All the terms as used herein (including technical and scientific terms) have the meanings as normally understood by a person skilled in the art, unless otherwise defined. For the sake of conciseness and/or clarity, well-known functions or constructions may not be described in detail.

The singular forms "a/an" and "the" as used in the specification, unless clearly indicated, all contain the plural forms. The wordings "comprising", "encompassing" and "containing" used in the specification indicate the presence of the claimed features, but do not expel the presence of one or more other features. The wording "and/or" as used in the specification includes any and all combinations of one or more of the relevant items listed.

As used herein, phrases such as "between X and Y" and "between about X and Y" should be interpreted to include X and Y. As used herein, phrases such as "between about X and Y" mean "between about X and about Y". As used herein, phrases such as "from about X to Y" mean "from about X to about Y"

When an element is referred to as being "on", "attached" to, "connected" to, "coupled" with, "contacting", etc., another element, it can be directly on, attached to, connected to, coupled with or contacting the other element or intervening elements may also be present.

In the specification, the terms "first", "second", and "third" are only used for the purpose of convenient description and are not intended to limit the present disclosure. Any technical features indicated by "first", "second" and "third" are interchangeable.

In the specification, words describing spatial relationships such as "up", "down", "above", "below", "front", "back", "top", "bottom" and the like may describe a relation of one feature to another feature in the drawings. It should be understood that these terms also encompass different orientations of the apparatus in use or operation, in addition to encompassing the orientations shown in the drawings. For example, when the apparatus shown in the drawings is turned over, the features previously described as being "below" other features may be described to be "above" other features at this time. The apparatus may also be otherwise oriented (rotated 90 degrees or at other orientations) and the relative spatial relationships will be correspondingly altered.

A modern base station antenna typically includes a plurality of radiating elements that may be mounted on an antenna substrate. The antenna substrate generally includes a feed board, a reflection board, and a calibration board, in which the feed board includes a feed network for feeding the radiating elements of the base station antenna, and the calibration board includes a calibration network for calibrating the amplitude and phase of signals transmitted to the feed network. The calibration board is usually provided with one or more electrical connectors for connecting cable interfaces from other devices or components (such as a remote radio unit (RRU)) to transmit signals between the base station antenna and the other devices or components.

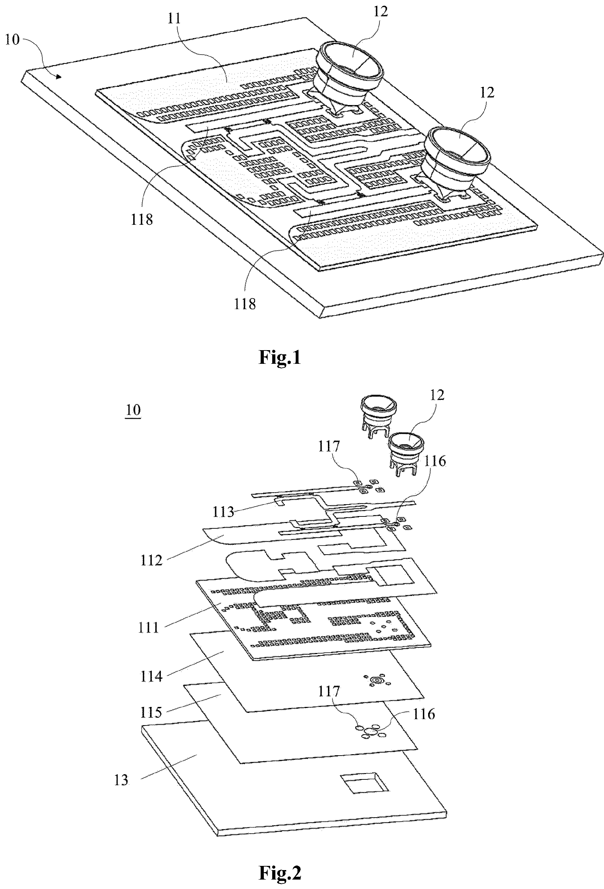

FIG. 1 and FIG. 2 show a calibration board 10 for a base station antenna in the prior art. FIG. 1 is a perspective view of the calibration board 10 and FIG. 2 is an exploded view of the calibration board 10. The calibration board 10 includes a printed circuit board 11 and one or more electrical connectors 12 mounted on the printed circuit board 11. The electrical connectors 12 are configured to connect cable interfaces from a device like an RRU, so as to transmit signals between the base station antenna and the RRU.

As shown more clearly in FIG. 2, the printed circuit board 11 may include: a substrate 111, which is typically configured as a dielectric layer; a first ground layer 112 and a conductive trace layer 113 disposed on an upper side or a first side of the substrate 111; a second ground layer 114 disposed on a lower side or a second side of the substrate 111; and a solder mask layer 115 disposed on a lower side of the second ground layer 114. The first ground layer 112 and the second ground layer 114 are typically metal layers, whereas the solder mask layer 115 is typically a paint layer. The conductive traces on the conductive trace layer 113 may be microstrip lines, strip lines, or other forms of conductors. The printed circuit board 11 may be mounted on a reflection board 13, which may comprise, for example, a metal sheet.

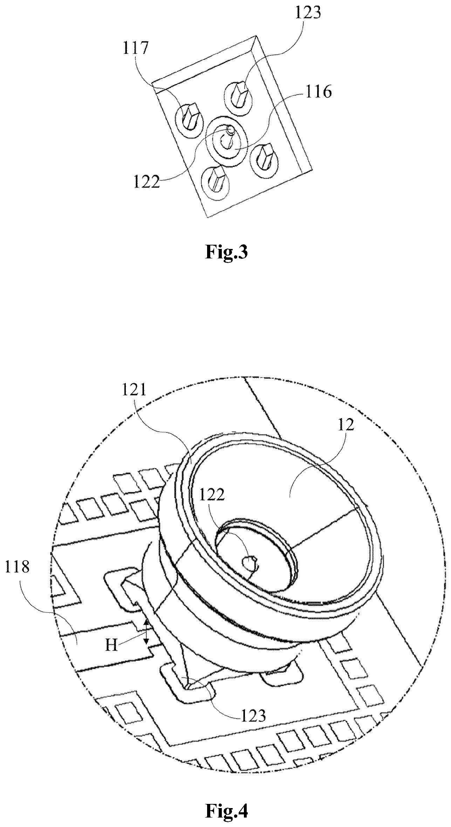

The electrical connector 12 is typically an electrical receptacle element. In the calibration board 10 of FIGS. 1 and 2, the electrical connector 12 is shown as a male straight receptacle (MSR) element. Referring to FIGS. 3 and 4, the MSR element includes a body 121, a conductor 122 located in the center of the body 121 and extending downward from a bottom of the body 121, and four ground pins 123 evenly distributed around the conductor 122 and extending downward from the bottom of the body 121. For the sake of mounting and fixing the electrical connector 12, the printed circuit board 11 is provided with a through hole 116 for receiving the conductor 122 of each electrical connector 12 and through holes 117 for receiving the ground pins 123 of each electrical connector 12. The conductor 122 and the ground pins 123 of the electrical connector 12 extend through the through hole 116 and the through holes 117 respectively and are soldered on the printed circuit board 11.

Referring to FIG. 4, when the electrical connector 12 is mounted on the printed circuit board 11, the conductor 122 of the electrical connector 12 is electrically connected to a corresponding conductive trace 118 on the printed circuit board 11, enabling the electrical connector 12 to transmit signals between the base station antenna and the RRU. The electrical connector 12 and the conductive trace 118 are generally located on the same side of the printed circuit board 11. In order to form an electrical connection between the conductor 122 of the electrical connector 12 and the conductive trace 118 of the printed circuit board 11, the through holes 116 and 117 are usually configured as plated through holes (PTH), an inner surface of which is plated with a copper layer for conducting current. Further, the conductive trace 118 extends to the through hole 116 for receiving the conductor 122 of the electrical connector 12, so as to form an electrical path. In this way, when the conductor 122 of the electrical connector 12 is inserted into the through hole 116 from the first side of the printed circuit board 11 and fixed to the printed circuit board 11 by being soldered on the second side of the printed circuit board 11, the current from the conductor 122 of the electrical connector 12 can flow from the second side of the printed circuit board 11 to the first side of the printed circuit board 11 via the through hole 116 and further flow to the conductive trace 118, thereby forming an electrical connection between the electrical connector 12 and the conductive traces 118.

However, it is found in practice that the calibration board 10 has some defects. First, in order to prevent the copper layer plated on the inner surfaces of the through holes 116 and 117 from being damaged during the process of inserting the conductor 122 and the ground pins 123 of the electrical connector 12 into the through holes 116 and 117, and in order to ensure that solder sufficiently fills the through holes 116 and 117 during soldering and thus to guarantee good electrical conductivity, the through holes 116 and 117 are sized to be larger than the conductor 122 and the ground pins 123 (as shown in FIG. 3), which may cause tilt of the electrical connector 12 upon being mounted on the printed circuit board 11, and accordingly may result in that the electrical connector 12 cannot connect with a cable interface mounted on a device like an RRU, especially in the case where the calibration board 10 includes two or more electrical connectors 12. Second, when the electrical connector 12 is being mounted on the printed circuit board 11, the bottom of the electrical connector 12 is spaced apart from the conductive traces 118 of the printed circuit board 11 with an extremely small gap H (about 0.3 mm, as shown in FIG. 4), which may lead to poor return loss or passive intermodulation (PIM) distortion performance. Additionally, since the conductive trace 118 must extend underneath the electrical connector 12 to form an electrical connection with the through hole 116 for receiving the conductor 122 of the electrical connector 12, when the electrical connector 12 is pressed or the printed circuit board 11 is deformed, the bottom of the electrical connector 12 may potentially come into contact with the conductive trace 118, resulting in a short circuit between the electrical connector 12 and the conductive trace 118.

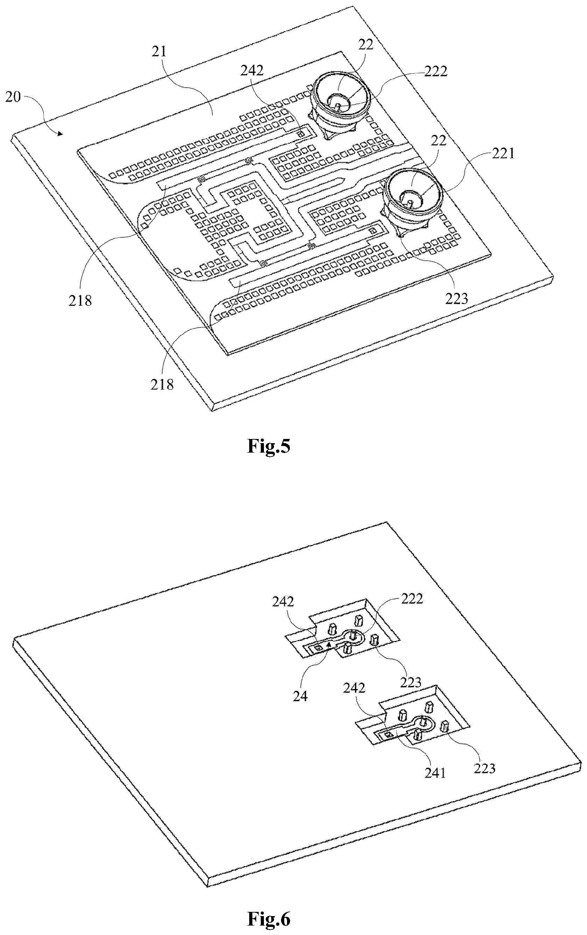

In order to solve at least one of the above problems, a calibration board 20 for a base station antenna according to the present disclosure is provided, which electrically connects a conductor of an electrical connector with a corresponding conductive trace on the calibration board 20 with an additional bypass, wherein the electrical connector and the conductive trace in electrical connection with the conductor of the electrical connector are located on a first side of the calibration board 20, and the bypass is located on a second side of the calibration board 20. The calibration board 20 according to embodiments of the present disclosure will be described in detail below with reference to FIGS. 5 to 7.

Referring to FIGS. 5 to 7, the calibration board 20 includes a printed circuit board 21 and one or more electrical connectors 22 mounted on the printed circuit board 21. The electrical connectors 22 are configured to connect cable interfaces from other devices or components (such as an RRU)), so as to transmit signals between the base station antenna and the other devices or components.

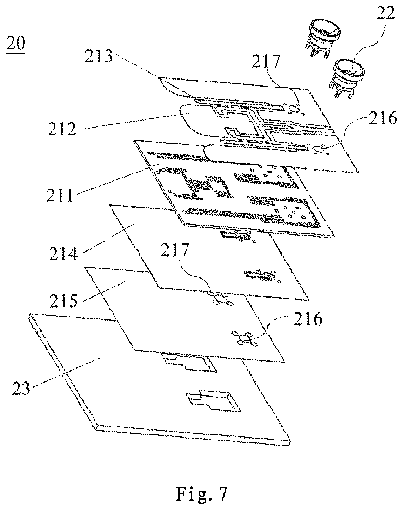

As shown in FIG. 7, similarly with the printed circuit board 11, the printed circuit board 21 may include: a substrate 211, which is typically configured as a dielectric layer; a first ground layer 212 and a conductive trace layer 213 disposed on an upper side or a first side of the substrate 211; a second ground layer 214 disposed on a lower side or a second side of the substrate 211; and a solder mask layer 215 disposed on a lower side of the second ground layer 214. The first ground layer 212 and the second ground layer 214 are typically metal layers, and the solder mask layer 215 is typically a paint layer. The conductive traces on the conductive trace layer 213 may be microstrip lines, strip lines, or other forms of conductors. The printed circuit board 21 may be mounted on a reflection board 23.

The electrical connectors 22 are shown as an MSR elements, each of which may include a body 221, a conductor 222 located in the center of the body 221 and extending downward from a bottom of the body 221, and four ground pins 223 evenly distributed around the conductor 222 and extending downward from the bottom of the body 221. For the sake of mounting and fixing the electrical connector 22, the printed circuit board 21 is provided with a through hole 216 for receiving the conductor 222 of each electrical connector 22 and through holes 217 for receiving the ground pins 223 of each electrical connector 22. The conductor 222 and the ground pins 223 of the electrical connector 22 extend through the through hole 216 and the through holes 217 respectively and are soldered on the printed circuit board 21.

When the electrical connector 22 is mounted on the printed circuit board 21, the conductor 222 of the electrical connector 22 is electrically connected to the corresponding conductive trace 218 on the printed circuit board 21, enabling the electrical connector 22 to transmit signals between the base station antenna and the other devices or components, such as an RRU. The electrical connector 22 and the conductive trace 218 are generally located on a first side of the printed circuit board 21. The conductive trace 218 may be a microstrip line. However, the present disclosure is not limited thereto, and the conductive traces 218 may also be strip lines or other forms of conductors.

Unlike the calibration board 10, in the calibration board 20 according to the present disclosure, the conductor 222 of the electrical connector 22 is electrically connected to the conductive trace 218 with a bypass 24 provided on a second side of the printed circuit board 21 that is opposite the first side, and the through hole 216 for receiving the conductor 222 of the electrical connector 22 is no longer used to conduct current. In other words, current will no longer be conducted from the conductor 222 of the electrical connector 22 to the conductive trace 218 via the through hole 216. This allows the through hole 216 to be sized substantially equal to the conductor 222 of the electrical connector 22 (since the through hole 216 no longer needs to be sized larger than the conductor 222 to allow sufficient flow-in of solder to form the electrical contact therein), so that the electrical connectors 22 can be positioned on the calibration board 20 without any tilt and can thus easily connect with cable interfaces of other devices or components (for example, the RRU).

A specific structure of the bypass 24 according to an embodiment of the present disclosure will be described with reference to FIG. 6. The bypass 24 may include a conductive trace 241 disposed on the second side of the printed circuit board 21, and a through hole 242 for electrically connecting the conductive trace 241 and the conductive trace 218. The through hole 242 is configured as a plated through hole (PTH), an inner surface of which is plated with a copper layer for conducting current. The through hole 242 and the through hole 216 for receiving the conductor 222 of the electrical connector 22 are spaced apart from each other, and electrically connected together by the conductive trace 241. In this way, when the conductor 222 of the electrical connector 22 is inserted into the through hole 216 from the first side of the printed circuit board 21 and fixed to the printed circuit board 21 by being soldered on the second side of the printed circuit board 21, the current from the conductor 222 of the electrical connector 22 can flow to the conductive trace 218 via the conductive trace 241 and the through hole 242, thereby forming an electrical connection between the electrical connector 22 and the conductive trace 218.

In embodiments according to the present disclosure, the conductive trace 241 may be a microstrip line. In other embodiments, the conductive trace 241 may be a coplanar waveguide, which may be implemented by including PTHs on either side of the conductive trace 241. However, the present disclosure is not limited thereto, and the conductive traces 241 may also be strip lines or other forms of conductors. Further, the through hole 242 for electrically connecting the conductive trace 241 and the conductive trace 218 may be of any suitable shape. For example, the through hole 242 may be in various shapes such as a circle, an oval, a square, a rhombus, a pentagon, a hexagon, or an irregular shape. In some embodiments according to the present disclosure, the through hole 242 may be shaped differently from the through holes 216 and 217, so as to distinguish the through hole 242 from the through holes 216 and 217.

As the through hole 216 for receiving the conductor 222 of the electrical connector 22 is no longer used to conduct current, in one embodiment according to the present disclosure, the through hole 216 may be configured as a non-PTH, the inner surface of which is not plated with a copper layer. The through hole 216 is sized substantially equal to the conductor 222 of the electrical connector 22 to enable the electrical connector 22 to be well positioned on the printed circuit board 21. Likewise, the through holes 217 for receiving the ground pins 223 of the electrical connector 22 may also be configured as non-PTHs and be sized substantially equal to the ground pins 223 of the electrical connector 22. However, it is to be noted that since the through holes 217 are only used for grounding, they may still be PTHs without negatively affecting electrical performances (such as return loss, PIM performance or the like) of the calibration board 20.

Further, since the through hole 216 for receiving the conductor 222 of the electrical connector 22 is no longer used to conduct current, in another embodiment according to the present disclosure, the conductive trace 218 does not need to be connected to the through hole 216, which makes it possible for the conductive trace 218 to be spaced apart from the through hole 216 by a distance. For example, as shown in FIG. 5, the conductive trace 218 may be spaced apart from the electrical connector 22 itself by a distance in a length direction of the conductive trace 218, so that the conductive trace 218 may not extend underneath the electrical connector 22. Accordingly, even if the electrical connector 22 is pressed or the printed circuit board 21 is deformed, the electrical connector 22 may not contact the conductive trace 218, thereby avoiding the short circuit between the electrical connector 22 and the conductive trace 218. Furthermore, since the conductive trace 218 is spaced apart from the through hole 216 by a distance, in this embodiment, the through hole 216 may still be a PTH without negatively affecting electrical performances (for example, return loss, PIM performance, etc.) of the calibration board 20, since the through hole 216 is no longer a part of the electrical path.

In the calibration board 20 according to the present disclosure, since the through hole 216 for receiving the conductor 222 of the electrical connector 22 is no longer used to conduct current, the through hole 216 may be sized substantially equal to the conductor 222, which enables the electrical connector 22 to be positioned on the calibration board 20 without any tilt, and thus enables the electrical connectors 22 to easily connect with cable interfaces of other devices or components (for example, an RRU). Further, since the conductive trace 218 no longer extends underneath the electrical connector 22, the poor return loss, the poor PIM distortion performance, and the potential short circuit between the conductive trace 218 and the electrical connector 22 caused by the extremely small gap between the conductive trace 218 and the bottom of the electrical connector 22 can be avoided.

Exemplary embodiments in accordance with the present disclosure have been described above with reference to the accompanying drawings. However, it shall be understood by those skilled in the art that various changes and modifications of the exemplary embodiments of the present disclosure can be made without departing from the spirit and scope of the present disclosure. All such variations and modifications are intended to be included within the scope of this disclosure as defined in the claims. The present disclosure is defined by the accompanying claims, and equivalents of these claims are also included.
The preferred aspects of the present disclosure may be summarized as follows:
1. A printed circuit board comprising a first through hole for receiving a conductor of an electrical connector and a first conductive trace for electrically connecting with the conductor of the electrical connector to transmit signals, characterized in that,
   the first conductive trace is provided on a first side of the printed circuit board, and the electrical connector is located on the same side of the first conductive trace when mounted on the printed circuit board; and
   the conductor of the electrical connector is electrically connected to the first conductive trace via a bypass provided on a second side of the printed circuit board opposite the first side.
2. The printed circuit board according to aspect 1, characterized in that the bypass includes a second conductive trace on the second side of the printed circuit board and a second through hole for electrically connecting the first conductive trace and the second conductive trace, wherein the second conductive trace is further configured to electrically connect the conductor of the electrical connector received in the first through hole and the second through hole.
3. The printed circuit board according to any one of the preceding aspects, in particular aspect 2, characterized in that the second through hole is configured as a plated through hole.
4. The printed circuit board according to any one of the preceding aspects, in particular aspect 2, characterized in that the second conductive trace is a microstrip line.
5. The printed circuit board according to any one of the preceding aspects, in particular aspect 2, characterized in that the second conductive trace is a coplanar waveguide.
6. The printed circuit board according to any one of any one of the preceding aspects, in particular aspects 1 to 5, characterized in that the first through hole is configured as a non-plated through hole.
7. The printed circuit board according to any one of any one of the preceding aspects, in particular aspects 1 to 5, characterized in that the first through hole is sized substantially equal to the conductor of the electrical connector.
8. The printed circuit board according to any one of any one of the preceding aspects, in particular aspects 1 to 5, characterized in that the first conductive trace is spaced apart from the electrical connector by a distance in a length direction of the first conductive trace.
9. The printed circuit board according to any one of any one of the preceding aspects, in particular aspects 1 to 5, characterized in that the first conductive trace is a microstrip line.
10. The printed circuit board according to any one of any one of the preceding aspects, in particular aspects 1 to 5, characterized in that the printed circuit board further includes a third through hole for receiving a ground pin of the electrical connector.
11. The printed circuit board according to any one of the preceding aspects, in particular aspect 10, characterized in that the third through hole is a plated through hole.
12. The printed circuit board according to any one of the preceding aspects, in particular aspect 10, characterized in that the third through hole is a non-plated through hole.
13. The printed circuit board according to any one of any one of the preceding aspects, in particular aspects 1 to 5, characterized in that the printed circuit board includes a first ground layer on the first side of the printed circuit board, a second ground layer on the second side of the printed circuit board, and a dielectric layer between the first ground layer and the second ground layer.
14. The printed circuit board according to any one of the preceding aspects, in particular aspect 13, characterized in that the first ground layer and/or the second ground layer are metal layers.
15. The printed circuit board according to any one of any one of the preceding aspects, in particular aspects 1 to 5, characterized in that the printed circuit board is configured as a calibration board for a base station antenna.
16. The printed circuit board according to any one of any one of the preceding aspects, in particular aspects 1 to 5, characterized in that the electrical connector is an electrical receptacle element for receiving a cable interface of a remote radio unit.
17. The printed circuit board according to any one of the preceding aspects, in particular aspect 16, characterized in that the electrical receptacle element is a male straight receptacle element.
18. A calibration board, characterized in that the calibration board comprises a printed circuit board according to any one of any one of the preceding aspects, in particular aspects 1 to 17 and one or more electrical connectors mounted on the printed circuit board.
19. A base station antenna, characterized in that the base station antenna comprises a calibration board including a printed circuit board according to any one of any one of the preceding aspects, in particular aspects 1 to 17 and one or more electrical connectors mounted on the printed circuit board.

## Claims

1. A printed circuit board comprising a first through hole for receiving a conductor of an electrical connector and a first conductive trace for electrically connecting with the conductor of the electrical connector to transmit signals, wherein:
the first conductive trace is provided on a first side of the printed circuit board, and the electrical connector is located on the same side of the first conductive trace when mounted on the printed circuit board; and
the conductor of the electrical connector is electrically connected to the first conductive trace via a bypass provided on a second side of the printed circuit board opposite the first side.

2. The printed circuit board of claim 1, wherein the bypass includes a second conductive trace on the second side of the printed circuit board and a second through hole for electrically connecting the first conductive trace and the second conductive trace, and wherein the second conductive trace is further configured to electrically connect the conductor of the electrical connector received in the first through hole and the second through hole.

3. The printed circuit board of claim 1 or 2, wherein the second through hole is configured as a plated through hole.

4. The printed circuit board of claim 2 or 3, wherein the second conductive trace is a microstrip line or a coplanar waveguide.

5. The printed circuit board of any of claims 1-4, wherein the first through hole is configured as a non-plated through hole.

6. The printed circuit board of any of claims 1-5, wherein the first through hole is sized substantially equal to the conductor of the electrical connector.

7. The printed circuit board of any of claims 1-6, wherein the first conductive trace is spaced apart from the electrical connector by a distance in a length direction of the first conductive trace.

8. The printed circuit board of any of claims 1-7, wherein the first conductive trace is a microstrip line.

9. The printed circuit board of any of claims 1-8, wherein the printed circuit board further includes a third through hole for receiving a ground pin of the electrical connector.

10. The printed circuit board of claim 9, wherein the third through hole is a plated through hole or a non-plated through hole.

11. The printed circuit board of any of claims 1-10, wherein the printed circuit board includes a first ground layer on the first side of the printed circuit board, a second ground layer on the second side of the printed circuit board, and a dielectric layer between the first ground layer and the second ground layer.

12. The printed circuit board of claim 11, wherein the first ground layer and/or the second ground layer are metal layers.

13. The printed circuit board of any of claims 1-12, wherein the printed circuit board is configured as a calibration board for a base station antenna and optionally comprises one or more electrical connectors mounted on the printed circuit board.

14. The printed circuit board of any of claims 1-13, wherein the electrical connector is an electrical receptacle element for receiving a cable interface of a remote radio unit, optionally wherein the electrical receptacle element is a male straight receptacle element.

15. A base station antenna comprising a calibration board including a printed circuit board according to any of claims 1-12 and one or more electrical connectors mounted on the printed circuit board.
